# DEMANDE DE BREVET EUROPEEN

(11) **EP 1 020 991 A1**
(43) Date de publication de la demande: **19.07.2000**
(21) Numéro de dépôt: 00400019.6
(22) Date de dépôt: 06.01.2000
(51) Int. Cl.: H03G 3/00, H03G 3/30

(54) **Récepteur radioélectrique ou électrique et son utilisation**

(30) Priorité: 11.01.1999 FR 9900176
(71) Demandeur: ALCATEL, 75008 Paris (FR)
(72) Inventeur: Berland, Corinne, 75010 Paris (FR); Brunet, Arnaud, 92500 Rueil Malmaison (FR)
(74) Mandataire: Hervouet, Sylvie

(57) **Abrégé**

Dans un téléphone mobile, on prévoit de réaliser une chaîne (2) de réception à gain variable, avec plusieurs organes (7, 11, 12) en cascade à gain variable en commandant (17) avec des retards (D1, D2) les gains d'amplification des organes à gain variable. On montre que le fait d'effectuer de telles commandes successivement conduit à avoir une chaîne de réception qui est plus réactive à une variation importante de conditions de réception.

## Description

La présente invention a pour objet un récepteur radioélectrique ou électrique utilisable notamment dans le domaine de la téléphonie mobile, et en particulier celle de type GSM. Le but de l'invention est de proposer des récepteurs présentant une grande réactivité à des variations, qui peuvent être importantes, de la dynamique des signaux admis sur leur entrée.

Dans le domaine de la téléphonie mobile, notamment de type GSM TDMA (Global System for Mobile, Time Division Multiple Access, qui signifie système global de téléphonie mobile à accès multiple à répartition dans le temps), les transmissions sont assurées par des canaux de transmission. Un canal de transmission est défini, entre une station de base et un téléphone mobile, d'une part par une bande de fréquence et d'autre part par une fenêtre temporelle réservée. Une bande de fréquence a typiquement une largeur de 200 KHz. D'autres largeurs sont envisageables.

Les fenêtres temporelles sont associées en nombre limité dans des trames de fenêtres. Dans un exemple, le nombre de fenêtres est de huit par trame. Pour des canaux empruntant une même bande de fréquence, il est alors possible d'échanger huit communications de type différent entre un ou plusieurs téléphones mobiles et une station de base.

En général, par mesures ou échanges d'informations entre un émetteur et un récepteur, le récepteur peut effectuer des réglages de réception en fonction de signaux que le récepteur reçoit. En effet, le niveau des signaux émis et reçus dépend des conditions de transmission et de l'éloignement entre l'émetteur et le récepteur.

La particularité d'un système de téléphonie mobile est que les stations de base sont réparties régulièrement sur un territoire de telle façon qu'un téléphone mobile puisse assez facilement transférer sa liaison avec une station de base à une liaison avec une station de base adjacente. Un tel système autorise au téléphone mobile de conserver une communication alors qu'il se déplace. En outre, un utilisateur avec un téléphone mobile n'est bien entendu pas le seul à converser avec une station de base ou avec des stations de base adjacentes à cette station de base. De ce fait, un téléphone mobile et ou une station de base sont souvent à l'écoute de signaux produits dans les fenêtres temporelles qui ne leur sont pas allouées.

Pour les systèmes de diffusion de type GPRS/HSCSD qui signifie General Packet Radio Service, High Speed Circuit Switch Data, dont le sens est service général de transmission de paquets d'informations radioélectriques, commutateur de circuit de données à haute vitesse, il est prévu qu'un téléphone mobile et/ou la station de base, pour des questions d'augmentation du débit d'informations, puisse émettre et ou recevoir des signaux radioélectriques pendant des fenêtres temporelles successives d'une même trame.

Ceci conduit à ce qu'un récepteur, celui d'un téléphone mobile ou d'une station de base, soit capable de rester en écoute pendant des fenêtres temporelles successives. Dans le cadre du GSM, des informations sont transmises durant des fenêtres temporelles. Un intervalle de temps, durant lequel aucune information utile n'est transmise, est disponible entre deux fenêtres temporelles de transmissions successives.

Dans une chaîne de réception, pour s'adapter à une grande diversité des amplitudes des signaux recevables, il est prévu des amplificateurs à gain variable. Une chaîne de réception comporte par exemple parmi ses organes un amplificateur précédant un mélangeur. Le mélangeur reçoit des signaux provenant de l'amplificateur et ceux produits par un oscillateur local. Le mélangeur produit des signaux en bande de base: en basse fréquence. Ces signaux en basse fréquence doivent être amplifiés par un autre amplificateur à gain variable. Ces signaux en bande de base avant ou après amplification doivent être filtrés.

Or les organes de la chaîne de réception ont des temps de propagation. Certains de ces temps de propagation sont générés par des constantes de temps des filtres. D'autres temps de propagation sont produits pour des raisons de synchronisation liées aux technologies utilisées pour les filtrages. Par ailleurs, d'autres traitements sont effectués dans une chaîne de réception, de sorte que le signal subit un retard de propagation à l'intérieur de la chaîne. Ce retard présente surtout l'inconvénient d'être supérieur à une tolérance temporelle de non-réception située dans le temps entre deux fenêtres successives d'une même trame.

Plus précisément, le problème se présente lorsque, d'une fenêtre à l'autre, les gains variables des amplificateurs à gain variable doivent passer d'une première valeur de réglage à une deuxième valeur de réglage très différente de la première. D'une part, une modification de gain s'applique de façon quasi instantanée à tous les organes de la chaîne après une instruction de changement. D'autre part, le signal met un certain temps à se propager à travers les différents organes. Suivant le moment où cette instruction de changement intervient, il peut en résulter un défaut de réception de premiers bits significatifs d'une fenêtre temporelle suivante ou de derniers bits significatifs d'une fenêtre temporelle précédente.

Il est connu dans l'état de la technique une solution pour remédier à ce problème. Cette solution consiste à dupliquer la chaîne de réception. Une première chaîne de réception est réglée, avec suffisamment d'anticipation, pour des signaux reçus pendant une première fenêtre temporelle. Une deuxième chaîne de réception étant réglée avec suffisamment d'anticipation pour des signaux reçus pendant une deuxième fenêtre temporelle.

Dans l'invention on a voulu remédier à cet inconvénient de temps de propagation associé au réglage des chaînes d'amplification, en augmentant la réactivité de la chaîne de réception, pour accepter, d'une fenêtre temporelle à l'autre d'une même trame de téléphonie mobile, une variation de dynamique des signaux reçus qui soit importante. Par ailleurs on a évité la solution onéreuse consistant à dupliquer la chaîne de réception.

Dans l'invention on a remarqué que le signal reçu se propageait dans la chaîne et y subissait petit à petit des retards dont le cumul était effectivement supérieur à la tolérance de non-réception évoquée ci-dessus. Ce faisant, on a remarqué que, dans celle chaîne, les signaux relatifs à la totalité d'une fenêtre temporelle sont libérés, par les différents organes en cascade de celle chaîne, à des dates qui se suivent dans le temps. Ainsi, un organe amont de la chaîne est libéré du traitement et de la transmission des signaux d'une fenêtre alors qu'un organe aval est encore en train de les traiter.

Dans l'invention on a alors décidé de provoquer, dans cet organe amont, une modification de son gain variable dès le moment où cet organe amont a traité tous les signaux de celle fenêtre. Il est alors possible pour cet organe amont d'avoir un temps suffisant de stabilisation de l'amplificateur à gain variable qu'il contient. Ce temps est suffisant pour que ce gain atteigne la valeur désirée pour des premiers signaux d'une fenêtre temporelle suivante à recevoir. Ainsi de suite, tous les organes en cascade de la chaîne de réception voient leur gain variable assigné à rejoindre une valeur de réglage pour une prochaine fenêtre à des dates successives. Ces dates successives dépendent du temps de propagation des signaux à traiter dans la chaîne. Les derniers amplificateurs à gain variable sollicités sont les amplificateurs à gain variable des organes en aval de la chaîne. Les organes de la chaîne sont généralement tous en cascade les uns avec les autres. Cependant certains d'entre eux peuvent être en parallèle.

L'invention a donc pour objet un récepteur radioélectrique ou électrique muni d'une chaîne de réception de signaux radioélectriques ou électriques comportant, entre une entrée de chaîne et une sortie de chaîne, plusieurs organes à gain variable, ces organes à gain variable recevant des commandes de gain, caractérisé en ce qu'il comporte des moyens de retard pour appliquer des commandes de gain aux organes à gain variable avec des retards qui sont croissants avec la position d'amont en aval de l'organe à gain variable dans la chaîne.

L'invention sera mieux comprise à la lecture de la description qui suit et à l'examen des figures qui l'accompagnent. Celles-ci ne sont présentées qu'à titre indicatif et nullement limitatif de l'invention. Les figures montrent:
- Figure 1 : la représentation schématique d'un récepteur radioélectrique muni des moyens de retard de l'invention ;
- Figure 2 : une représentation de fenêtres temporelles dans une trame de type GSM pour des applications de type GPRS/HSCSD, et la matérialisation des durées neutralisées entre deux fenêtres temporelles successives.

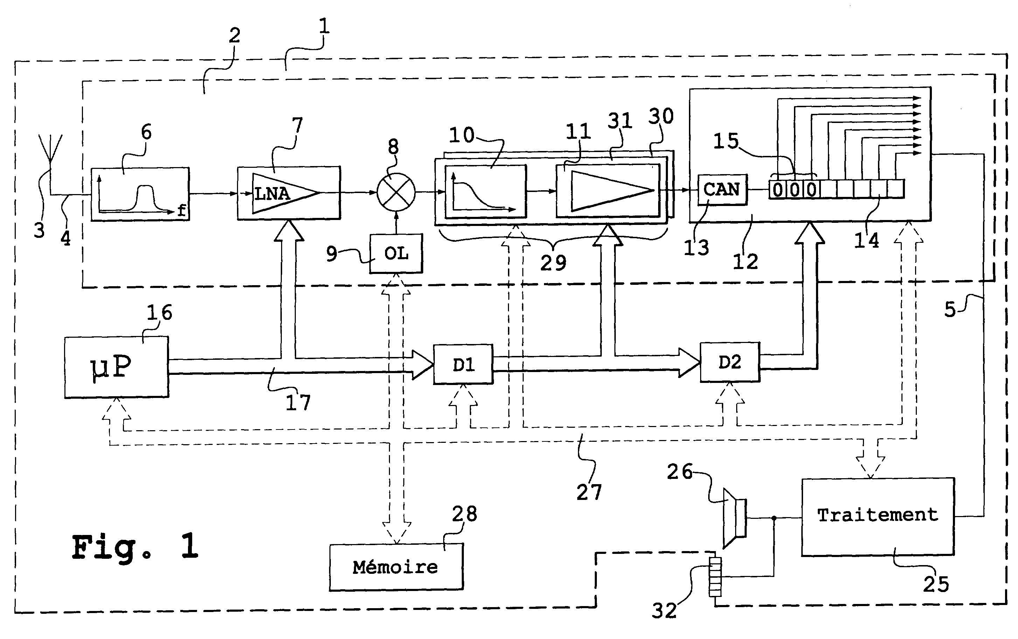

La figure 1 montre un récepteur radioélectrique selon l'invention. Ce récepteur radioélectrique 1 comporte une chaîne 2 de réception des signaux radioélectriques. Dans ce but cette chaîne 2 est reliée à une antenne 3 qui est par exemple celle d'une station de base ou d'un téléphone mobile. La chaîne 2 comporte, entre une entrée 4 de la chaîne et une sortie 5 de la chaîne, un certain nombre d'organes dont certains sont à gain variable. Pour fixer les idées, directement en aval de l'antenne 3 est disposé un filtre passe bande 6 centré sur la bande passante de réception. Le but du filtre 6 est de transmettre le moins de bruit possible aux organes en aval. En sortie du filtre 6 est disposé un amplificateur à faible bruit 7 (LNA, Low Noise Amplifier) qui a pour objet d'amplifier le signal reçu sur l'antenne 3 avec un niveau suffisant pour que celui-ci puisse attaquer d'une manière significative un mélangeur 8.

Le mélangeur 8 reçoit par ailleurs un signal d'un oscillateur local 9. Le but de ces oscillateurs et mélangeurs est de produire, en sortie du mélangeur théorique 8 un signal en bande de base, c'est-à-dire affranchi de la fréquence porteuse à très haute fréquence, dans le cas d'une architecture à conversion directe.

Le signal en bande de base disponible en sortie du mélangeur 8 a par exemple une largeur de 200 KHz. Le signal délivré par le mélangeur 8 comporte, bien entendu, d'autres composantes de fréquence qui sont filtrées dans un filtre 10 basse fréquence. Ce filtre 10 basse fréquence est en fait constitué d'un ensemble de filtres basse fréquence en cascade les uns des autres. Chacun d'eux a une fréquence de coupure avoisinant 200 KHz. Chacun d'eux apporte un retard de propagation qui dépend de la fréquence de coupure du filtre et de l'ordre du filtre. Le filtre 10 est suivi d'un amplificateur 11 qui attaque un circuit 12 de conversion analogique numérique. Le circuit 12 comporte un convertisseur 13 analogique numérique proprement dit, relié à un amplificateur numérique 14 à gain variable.

Un tel amplificateur numérique 14 à gain variable peut être réalisé sous la forme d'un registre simple stockant régulièrement chacun des échantillons mesurés et quantifiés par le convertisseur 13. Le registre produit un message avec une dynamique inférieure à la dynamique de quantification du convertisseur 13. Dans un exemple le convertisseur 13 quantifie les signaux qu'il reçoit sur N bits. Les N bits sont stockés dans le registre 14. L'amplification à gain variable consiste à prélever un nombre inférieur de bits, par exemple n bits, les n premiers bits significatifs de poids les plus forts, en ayant enlevé des signaux quantifiés les zéros en poids forts 15 non significatifs. Les gains variables des organes 7, 11 et 12 sont imposés par un circuit de commande 16. Dans un exemple le circuit de commande 16 est un microprocesseur. Il est relié à ces organes par un bus de commande 17.

Très schématiquement représenté, on a indiqué que lorsqu'un ordre de mutation du gain variable d'un organe à gain variable est issu par le microprocesseur 16, il est appliqué directement, sans délai, par le bus 17 à l'amplificateur 7. Il est appliqué avec un délai D1 à l'amplificateur 11. Il est appliqué avec un délai D1 + D2 à l'amplificateur numérique 12. La représentation montrée est tout à fait symbolique. Dans la pratique le microprocesseur possède tous les moyens pour placer sur le bus 17 les niveaux de réglage requis, avec les adresses des organes désignés, et en les imposant progressivement dans le temps. Ainsi sur le bus 17 sera d'abord placé la consigne de réglage de l'amplificateur 7, puis celle de l'amplificateur 11, puis enfin celle de l'amplificateur 12.

Dans la pratique les écarts séparant ces différentes applications sont programmables. Dans un exemple entre l'instant d'application de la consigne de réglage de l'amplificateur 7 et l'instant d'application de la consigne de réglage de l'amplificateur 11, on pourra faire décompter un compteur qui aura été préalablement chargé par une valeur de paramétrage constituant justement la valeur programmable envisagée. Plus cette valeur de paramétrage est élevée, plus le décomptage est long et plus le retard de la commande de l'amplificateur 11 par rapport à la commande de l'amplificateur 7 sera importante. On agit de même pour la commande de l'amplificateur numérique 12.

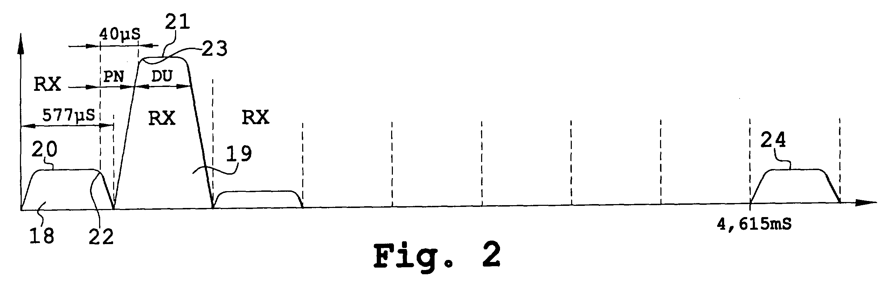

La figure 2 montre dans une trame de type GSM, de 4,615 millisecondes, huit fenêtres temporelles de 577 microsecondes chacune. Une fenêtre 18 est temporellement antérieure directement à une fenêtre temporelle 19. Dans les durées de 577 microsecondes de chaque fenêtre temporelle, seule une durée DU utile est exploitable pour transmettre des signaux. Une durée neutralisée PN entre deux fenêtres permet de tenir compte de niveaux différents respectivement 20 et 21 de signaux reçus pendant les fenêtres 18 et 19 pour régler en conséquence les gains des organes 7, 11 et 12. Comme montré sur la figure, entre la fin 22 de la durée utile de la fenêtre 18 et le début 23 de la durée utile de la fenêtre 19, la tolérance de non-réception est inférieure à la durée de propagation totale des signaux dans la chaîne 2. De ce fait, si on n'adoptait pas le principe de l'invention, les signaux de la fenêtre 19 seraient déjà reçus par l'amplificateur 7 alors que les signaux de la fenêtre 18 seraient encore en cours de traitement dans l'amplificateur numérique 12. Le gain pour un de ces signaux serait désadapté pour l'autre.

La fenêtre 18 se retrouve, une trame plus tard, en une fenêtre 24. Les signaux contenus dans ces fenêtres sont traités dans un circuit de traitement 25, relié à la sortie du circuit amplificateur numérique 12. Normalement ces signaux délivrés sont des signaux de parole transmis à un haut-parleur 26. Cependant la voie de transmission peut également être utilisée pour transmettre des signaux de signalisation. Ceux-ci sont alors acheminés par un bus de signalisation 27 jusqu'au microprocesseur 16 qui peut les stocker dans une mémoire 28.

Il peut arriver que les signaux à recevoir soient à grande dynamique : par exemple leur niveau sera élevé comme celui de la fenêtre temporelle 19. Dans ce cas, il est possible qu'un des filtres passe bas d'un groupement 29 de filtres passe bas ne soit pas nécessaire. Dans ce groupement 29 de filtres, chaque filtre est constitué comme un filtre 30 par l'association d'un filtre 10 proprement dit et d'un amplificateur 11. Des filtres 30 et 31 d'un groupement sont en fait en cascade les uns des autres. Leurs temps de propagation s'additionnent.

En effet le niveau de bruit en propagation est toujours le même. Donc si le signal est fort, relativement le bruit devient faible. On peut alors se satisfaire d'une amplification faible, et les besoins en filtrage sont moins grands. Par exemple le filtre 31, pour la fenêtre 19, sera supprimé. Dans ce cas, le retard apporté par le groupement 29 de filtres à la propagation des signaux de la fenêtre 19 sera moins important que si le filtre 31 avait été présent. Par conséquent, dans le microprocesseur 16 on modifiera, en le diminuant dans ce cas-là, les retards D1 et D1 + D2, appliqués à la commande de l'amplificateur 11 et de l'amplificateur numérique 12. Dans ce cas, les retards seront paramétrés en fonction des signaux radioélectriques reçus par la chaîne.

De même qu'avec les filtres 30 et 31 le groupement 29 peut contenir un ou plusieurs amplificateurs en cascade, l'amplificateur 7 et le filtre 6 peuvent être réalisés sous la forme d'un ou de plusieurs ensembles en cascade.

L'utilisation du récepteur radioélectrique de l'invention est particulièrement utile dans un téléphone mobile 1 de type GSM. Un tel téléphone peut néanmoins être utilisé comme modem de transmission radioélectrique. En effet, il suffit de relier au circuit de traitement 25 un port 32 pour transformer la chaîne 2 en une chaîne de traitement de signal en réception radioélectrique. Dans ce cas la partie émission du téléphone mobile sera également reliée à un port du même type que 32.

## Revendications

1. Récepteur (1) radioélectrique ou électrique muni d'une chaîne (2) de réception de signaux radioélectriques ou électriques comportant, entre une entrée (4) de chaîne et une sortie (5) de chaîne, plusieurs organes (7, 11, 12) à gain variable, ces organes à gain variable recevant (17) des commandes de gain, caractérisé en ce qu'il comporte des moyens (D1, D2) de retard pour appliquer des commandes de gain aux organes à gain variable avec des retards qui sont croissants d'amont en aval avec la position de l'organe à gain variable dans la chaîne.

2. Récepteur selon la revendication 1, caractérisé en ce que les retards des moyens de retard sont paramétrables.

3. Récepteur selon la revendication 2, caractérisé en ce que les retards des moyens de retards sont paramétrables en fonction de signaux radioélectriques reçus par la chaîne.

4. Récepteur selon l'une des revendications 1 à 3, caractérisé en ce que les organes à gain variable comportent un ou plusieurs premiers amplificateurs (7) à gain variable raccordé en entrée d'un mélangeur (8), un ou plusieurs deuxièmes amplificateurs (11) à gain variable raccordé en sortie du mélangeur, et un circuit (12) de conversion analogique numérique à gain variable raccordé à la sortie du deuxième amplificateur à gain variable.

5. Récepteur selon la revendication 4, caractérisé en ce que le circuit de conversion analogique numérique à gain variable comporte un registre (14).

6. Utilisation d'un récepteur selon l'une des revendications 1 à 5 dans un téléphone mobile de type GSM.
